Europäisches Patentamt

European Patent Office

Office européen des brevets

(19)

(11) Veröffentlichungsnummer : **0 353 508 B1**

(12) **EUROPÄISCHE PATENTSCHRIFT**

(45) Veröffentlichungstag der Patentschrift :
**21.09.94 Patentblatt 94/38**

(51) Int. Cl.⁵ : **H03K 19/0175**

(21) Anmeldenummer : **89112776.3**

(22) Anmeldetag : **12.07.89**

(54) **ECL-CMOS-Wandler.**

(30) Priorität : **22.07.88 DE 3825010**

(43) Veröffentlichungstag der Anmeldung :
**07.02.90 Patentblatt 90/06**

(45) Bekanntmachung des Hinweises auf die
Patenterteilung :
**21.09.94 Patentblatt 94/38**

(84) Benannte Vertragsstaaten :
**DE FR GB**

(56) Entgegenhaltungen :
EP-A- 0 142 167
EP-A- 0 146 910
EP-A- 0 318 018

(56) Entgegenhaltungen :
US-A- 4 453 095
US-A- 4 645 951
PATENT ABSTRACTS OF JAPAN, Band 8, Nr.
181 (E-261)[1618], 21. August 1984; & JP-A-59
74 732 (Hitachi Seisakusho K.K.) 27-04-1984
PATENT ABSTRACTS OF JAPAN, Band 4, Nr. 5
(E-165), 16. Januar 1980, Seite 154 E165; &
JP-A-54 147 073 (DAINI SEIKOSHA K.K.) 16-
11-1979

(73) Patentinhaber : **SIEMENS
AKTIENGESELLSCHAFT
Wittelsbacherplatz 2
D-80333 München (DE)**

(72) Erfinder : **Müllner, Ernst, Dipl.-Ing.
Erzgiessereistrasse 21
D-8000 München 2 (DE)**

## Beschreibung

Die Erfindung betrifft ECL-CMOS-Wandler zur Wandlung von ECL-Pegel in CMOS-Pegel.

ECL- und CMOS-Schaltungen sind in der Halbleiterschaltungstechnik weit verbreitet. Dabei besitzen die ECL-Schaltungen (= emittergekoppelte Logik) die kleinsten Schaltzeiten aller Logikfamilien. Diese liegen im Bereich von wenigen Nanosekunden und reichen zum Teil auch unter eine Nanosekunde. In CMOS-Schaltungen werden komplementäre MOSFET-Transistoren eingesetzt. Dabei ist die ohmsche Ausgangsbelastung der CMOS-Schaltungen wegen der hohen Eingangswiderstände sehr gering. Je größer dabei die kapazitive Ausgangsbelastung ist, desto größer wird auch die Schaltzeit werden. Bei größerer kapazitiver Ausgangslast liegt sie in der Größenordnung von etwa 10 ns und darüber.

Neben der MOS-Schaltungstechnik hat sich in den letzten Jahren eine Bipolar-CMOS-(BICMOS)-Schaltungstechnologie entwickelt, die besonders bei zeitkritischen und kompakten Schaltungen eingesetzt wird. Durch die Verwendung von BICMOS-Schaltungen ergeben sich Vorteile aus der MOS- als auch aus der Bipolar-Schaltungstechnologie. Hohe Packungsdichten und kleine statische Verlustleistung, welche beispielsweise für Schaltungen aus der CMOS-Schaltungstechnik charakteristisch sind, eine geringe Offsetspannung sowie eine sehr hohe Verarbeitungsgeschwindigkeit, welche für Schaltungen in ECL- bzw. Bipolar-Schaltungstechnik kennzeichnend sind, sind Merkmale, die für eine Verwendung von Schaltungen in "BICMOS"-Schaltungstechnologie sprechen. Mit Hilfe der "BICMOS"-Schaltungstechnologie können mithin sehr hohe Arbeitsgeschwindigkeiten erreicht werden, indem man die Schaltungsteile mit höherer Verarbeitungsgeschwindigkeit in ECL-Schaltungstechnik realisiert, zeitunkritischere Schaltungsteile dagegen in CMOS-Schaltungstechnik.

Zwischen diesen beiden Schaltungsblöcken sind jeweils schnelle Pegelwandler erforderlich, wobei die Wandlung von ECL-Pegel in CMOS-Pegel technisch schwieriger zu realisieren ist als eine umgekehrte Wandlung von CMOS-Pegel in ECL-Pegel.

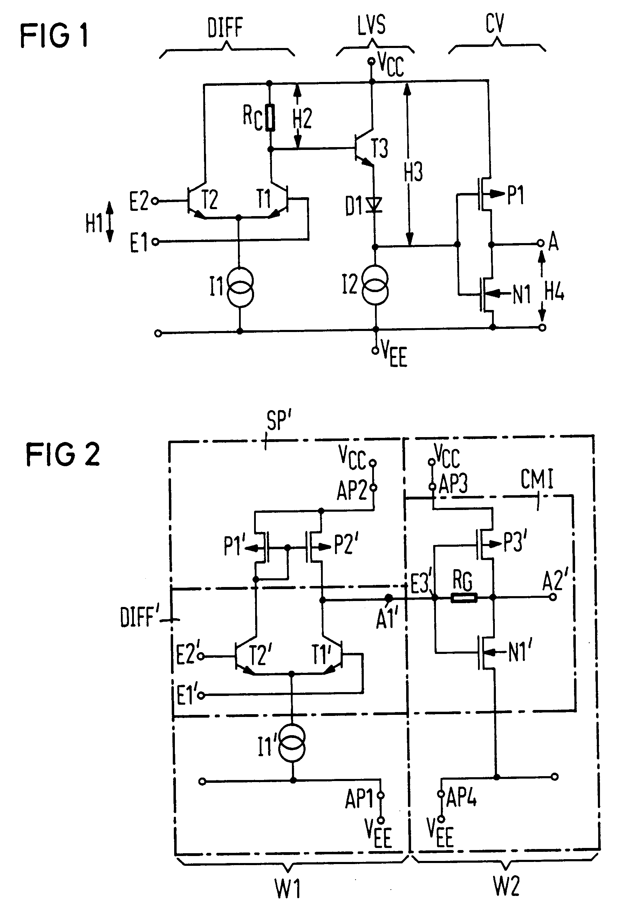

Figur 1 zeigt ein zum Stand der Technik gehörenden ECL-CMOS-Wandler, bei dem zunächst ein bipolarer Differenzverstärker benutzt wird, um den ECL-Pegel auf einen Zwischenpegel zu verstärken. Dieser Pegel wird durch die Wahl eines oder mehrerer Kollektorwiderstände eingestellt. Die weitere Verstärkung auf den CMOS-Pegel erfolgt durch eine CMOS-Schaltung. Hierzu kann entweder ein CMOS-Differenzverstärker oder eine CMOS- Inverterstufe verwendet werden, wobei die nötige Pegelanpassung mit Emitterfolger-Levelshiftern erreicht wird, was zusätzlich Leistung verbraucht. Die in Figur 1 dargestellte Schaltung besteht aus einem bipolaren asymmetrischen-Differenzverstärker, der als Spannungsverstärker wirkt, einer nachfolgenden Stufe eines Emitterfolgers (auch als Levelshifter bezeichnet) und eine CMOS-Ausgangsstufe. Aus der Literatur sind weitere ECL-CMOS-Wandler bekannt, beispielsweise aus der Veröffentlichung IEEE ISSCC, 1986, S. 212-213, Static RAMs, THPM 16.6: "13 ns/ 500 mW 64 Kb ECL RAM" von Katsumi Ogiue et al, Hitachi Device Development Center, Tokio, Japan. In Figur 3 der genannten Veröffentlichung ist ein ECL-CMOS-Wandler angegeben, der aus einem symmetrischen Differenzverstärker, Levelshifter und einer CMOS-Ausgangsstufe besteht. Die ECL-Pegel schwanken hier zwischen -0,9 Volt bis -1,7 Volt und werden durch den ECL-CMOS-Wandler auf einen MOS-Pegel von 0 bis -5,2 Volt gewandelt.

Aus der europäischen Patentschrift EP-A-O 146 910 ist eine Pegelkonverterschaltung, insbesondere eine ECL-CMOS-Pegelkonverterschaltung, bekannt, deren Spannungs/Stromwandler zwar eine Stromquelle, eine Differenzstufe und eine Stromspiegelschaltung aufweist, wobei jedoch der Spannungs/Stromwandler ausgangsseitig mit einer Stromverstärkungsschaltung verbunden ist, die beispielsweise kein Rückkopplungselement besitzt.

In den PATENTS ABSTRACTS OF JAPAN, Band 8, Nr. 181 (E-261) (1618), 21. August 1984; & JP-A-59 74 732; 27/04/1984 ist eine ECL-CMOS-Pegelkonverterschaltung gezeigt, deren Spannungs/Stromwandler eine Stromquelle, eine Differenzstufe mit MOS-Transistoren und eine Stromspiegelschaltung aufweist und deren Strom/Spannungswandler aus einer CMOS-Inverterstufe besteht, die aber keine Rückkopplung besitzt und dadurch beispielsweise eine hohe Empfindlichkeit gegenüber Temperatur- und Betriebspannungsschwankungen gegeben ist.

Aus der europäischen Patentanmeldung 0 142 167 A2 ist ein Inverter mit Rückkopplungswiderstand bekannt, dem als Strom/Spannungswandler ein Kondensator vorgeschaltet ist.

Ferner ist aus der europäischen Patentanmeldung 0 318 018 A2, veröffentlicht am 31.05.89, eine ECL/CMOS-Converterschaltung bekannt, die einen Spannungs/Stromwandler mit einer Differenzverstärkerstufe und einer Stromquelle besitzt und die über einen Kondensator mit einer durch einen Widerstand rückgekoppelten Inverterstufe verbunden ist.

Wird in dem ECL-CMOS-Wandler in der Ausgangsstufe eine CMOS-Inverstufe verwendet, wirken sich Temperatur und Betriebsspannungsschwankungen sehr stark aus, da die Pegel aus dem bipolaren Differenzverstärker sich auf die positive Versorgungsspannung beziehen, während die Schwelle des CMOS-Verstärkers

2

immer in der Mitte zwischen beiden Versorgungsspannungen (ungefähr - 2,5 Volt) liegt.

Der Erfindung liegt die Aufgabe zugrunde, einen ECL-CMOS-Wandler vorzustellen, der in möglichst kurzer Verarbeitungzeit ECL- in CMOS-Pegel wandeln kann und bei dem Auswirkungen durch Temperatur- und Betriebsspannungsschwankungen möglichst gering sind.

Diese Aufgaben werden durch die Merkmale des Patentanspruchs 1 gelöst.

Die mit der Erfindung erzielten Vorteile bestehen insbesondere darin, daß durch das erfindungsgemäße Schaltungsprinzip keinerlei Probleme der Pegelanpassung zwischen der bipolaren und der CMOS-Stufe bestehen, daß keinerlei Emitterfolger-Levelshifter mehr benötigt werden und so eine reduzierte Leistungsaufnahme ermöglicht wird. Ein weiterer Vorteil des erfindungsgemäßen ECL-CMOS-Wandlers besteht darin, daß Streuungen der Widerstandswerte, welche bei der Herstellung solcher Schaltungen auftreten können, ausgeglichen werden und die Funktionsfähigkeit des ECL-CMOS-Wandlers nicht beeinträchtigen.

Ein Ausführungsbeispiel der Erfindung ist in der Zeichnung Figur 2 dargestellt und wird im folgenden näher beschrieben. Es zeigen:

Figur 1      einen zum Stand der Technik gehörenden ECL-CMOS-Wandler mit einem bipolaren Differenzverstärker, Emitterfolger und CMOS-Verstärker,

Figur 2      eine Realisierung eines erfindungsgemäßen ECL-CMOS-Wandlers, bestehend aus einem Spannungs/Stromwandler und einem nachgeschalteten Strom/Spannungswandler.

Der in Figur 1 gezeigte und zum Stand der Technik gehörende ECL-CMOS-Wandler enthält einen bipolaren Differenzverstärker DIFF mit nachgeschaltetem Emitterfolger LVS (auch Levelshifter genannt) und einen abschließenden CMOS-Verstärker CV. Sowohl der bipolare Differenzverstärker als auch der CMOS-Verstärker sind als Spannungsverstärker geschaltet, so daß beide einen hochohmigen Eingang und einen niederohmigen Ausgang aufweisen.

Der bipolare Differenzverstärker DIFF enthält zwei bipolare npn-Transistoren T1, T2, sowie einen Kollektorwiderstand $R_C$, über den eine asymmetrische Auskopplung für den nachfolgenden Emitterfolger LVS stattfindet. Je ein Basisanschluß des ersten und zweiten bipolaren npn-Transistors T1 und T2 bilden einen Eingang E1, E2 des Differenzverstärkers, beide Emitteranschlüsse der beiden genannten Transistoren sind über eine Stromquelle I1 mit einer ersten Versorgungsspannung $V_{EE}$ (beispielsweise -4,5 Volt) verbunden. Der Kollektorausgang des ersten bipolaren npn-Transistors T1 ist über einen Kollektorwiderstand $R_C$ und der Kollektoranschluß des zweiten bipolaren npn-Transistors ist direkt mit der zweiten Versorgungsspannung $V_{CC}$ (beispielsweise 0 Volt) verschaltet. Am Eingang des bipolaren Differenzverstärkers werden Hübe H1 von ungefähr 200 mv angelegt, die den ECL-Hüben entsprechen. Über den Kollektorwiderstand $R_C$ können anschließend Hübe H2 von ungefähr +1,5 Volt gemessen werden, die in dem angeschlossenen Emitterfolger auf einen um 1,7 Volt abgesenkten Zwischenhub H3 von 1,5 Volt umgesetzt werden. Der Emitterfolger besteht nach Figur 1 aus einem bipolaren npn-Transistor T3, an dessem Emitteranschluß eine Diode D1 mit ihrer Anodenseite angeschlossen ist. Hierbei ist der Kollektoranschluß des dritten bipolaren npn-Transistors T3 mit der zweiten Versorgungsspannung $V_{CC}$ (beispielsweise 0 Volt) und der Basisanschluß desselbigen Transistors mit dem Kollektoranschluß des ersten bipolaren npn-Transistors T1 im Differenzverstärker DIFF verschaltet. Der gemessene Zwischenhub H3 ist zwischen dem Kathodenanschluß der Diode D1 und dem Kollektoranschluß des dritten npn-Transistors abgreifbar. Weiterhin angeschlossen an der Kathodenseite der Diode D1 ist eine zweite Stromquelle I2, die mit ihrem zweiten Anschluß an der ersten Versorgungsspannung $V_{EE}$ (beispielsweise -4,5 Volt) liegt. Als Ausgangsstufe des ECL-CMOS-Wandlers ist ein CMOS-Verstärker CV vorgesehen, der aus einem p-Kanal-Enhancement-MOSFET P1 und aus einem n-Kanal-Enhancement-MOSFET N1 aufgebaut ist, wobei ein erster Anschluß des p-Kanal-MOSFET P1 mit der zweiten Versorgungsspannung $V_{CC}$ und ein erster Anschluß des n-Kanal-MOSFET N1 mit der ersten Versorgungsspannung $V_{EE}$ verschaltet ist. Die Gateanschlüsse des n- und des p-Kanal-MOSFET P1, N1 bilden gemeinsam den Eingang des CMOS-Verstärkers und sind mit der Kathodenseite der Diode D1 des Emitterfolgers LVS verbunden. Der Ausgang des CMOS-Verstärkers wird durch die beiden zweiten Anschlüsse das p- und n-Kanal-Enhancement-MOSFET P1, N1 gebildet, wobei hier Hübe H4 von +4,5 Volt abgegriffen werden können. Die Schaltschwelle des CMOS-Verstärkers an seinem Eingang liegt hier, wie bereits eingangs erwähnt, etwa in der Mitte zwischen den beiden Versorgungsspannungen $V_{CC}$ und $V_{EE}$, also ungefähr bei -2,25 Volt (bezogen auf $V_{CC}$). Aufgrund von Temperatur- und Betriebsspannungsschwankungen kann nun ein Pegel am Ausgang des Emitterfolgers (bezogen auf $V_{CC}$) so stark beeinflußt werden, daß der Zwischenhub H3 nicht mehr symmetrisch um eine Schaltschwelle für den CMOS-Verstärker von ungefähr -2,25 Volt (bezogen auf ($V_{CC}$) liegt. Im folgenden wird nun in Figur 2 ein erfindungsgemäßer ECL-CMOS-Wandler beschrieben, der weitgehend unabhängig von Temperatur- und Betriebsspannungsschwankungen ECL- in CMOS-Pegel wandelt.

Der in Figur 2 dargestellte erfindungsgemäße ECL-CMOS-Wandler enthält einen Spannungs/Stromwandler W1 sowie einen Strom/Spannungswandler W2, wobei der Strom/Spannungswandler W2 in Reihe mit dem Spannungs/Stromwandler W1 geschaltet ist. Hieraus resultieren hochohmige

EP 0 353 508 B1

Eingänge E1′ und E2′ für den Spannungs/Stromwandler W1 sowie einen niederohmigen Eingang E3′ für den Strom/Spannungswandler W2, sowie ein hochohmiger Ausgang A1′ für den Spannungs/Stromwandler W1 und einen niederohmigen Ausgang A2′ für den Strom/Spannungswandler W2. Die bewußte Fehlanpassung des Spannungs/Stromwandlers W1 an den Strom/Spannungswandler W2 ist unter dem Prinzip des "mismatched amplifiers" in der Veröffentlichung von "The design of wide-band transistor feedback amplifiers" von E. M. Cherry et al in Proc. IEE, Vol. 110, No. 2, Febr. 1963, schon seit längerem bekannt. Dieses Prinzip wurde bisher jedoch dazu benutzt, um eine hohe Bandbreite bei Bipolarverstärkern zu erzielen (siehe hierzu R. Reimann, H.M. Rein: "4 Gb/s Limiting Amplifier for Optical-Fiber Receivers", ISSCC Digest of Techn. Papers, Febr. 1987, S. 172), während es im erfindungsgemäßen ECL-CMOS-Wandler dazu benutzt wird, um Parameter-, Temperatur- und Versorgungsspannungsschwankungen bei einer "BICMOS"-Schaltung auszugleichen.

Im einzelnen besteht der Spannungs/Stromwandler aus einer Stromquelle I1′, einem Differenzverstärker DIFF′ sowie einer Stromspiegelschaltung SP′, während der Strom/Spannungswandler W2 aus einer rückgekoppelten CMOS-Inverterstufe CMI aufgebaut ist. Der Differenzverstärker DIFF′ enthält zwei bipolare npn-Transistoren T1′ und T2′, wobei der erste Eingang E1′ mit dem Basisanschluß des ersten bipolaren npn-Transistors T1′ und der zweite Eingang E2′ mit dem Basisanschluß des zweiten bipolaren npn-Transistors T2′ verschaltet ist. Der Emitteranschluß des ersten und zweiten npn-Transistors T1′ und T2′ sind gemeinsam über die Stromquelle I1′ mit der ersten Versorgungsspannung $V_{EE}$ verbunden, wobei die Stromquelle I1′ mit Hilfe von MOS-Feldeffekttransistoren aufgebaut wird und die erste Versorgungsspannung $V_{EE}$ typischerweise bei -4,5 Volt liegt. Dabei ist die Angabe der ersten Versorgungsspannung sowie alle weiteren Spannungsangaben auf $V_{CC}$ bezogen. Es ist ebenfalls möglich, den ECL-CMOS-Wandler mit Versorgungsspannungen zu betreiben, die von der typischen Versorgungsspannung $V_{EE}$ = -4,5 Volt abweichen. Ab einer Spannung von $V_{EE}$ = -5 Volt ist auch der Aufbau einer Stromquelle, bestehend aus bipolaren Transistoren möglich. Der Kollektoranschluß des ersten und zweiten bipolaren npn-Transistors T1′ und T2′ sind mit der Stromspiegelschaltung SP′ verschaltet, wobei der Kollektoranschluß des ersten bipolaren npn-Transistors T1′ gleichzeitig den Ausgang A1′ des Spannungs/Stromwandlers W1 bildet. Die Stromspiegelschaltung SP′ wird mit Hilfe von zwei Enhancement-p-Kanal-MOSFET P1′ und P2′ aufgebaut, wobei die Gateanschlüsse der beiden p-Kanal-MOS-Feldeffekttransistoren P1′ und P2′, gemeinsam mit einem ersten Anschluß des ersten p-Kanal-MOS-Feldeffekttransistors P1′, mit dem Kollektoranschluß des zweiten bipolaren npn-Transistors T2′ verschaltet ist. Weiterhin ist ein erster Anschluß des zweiten p-Kanal-MOS-Feldeffekttransistors P2′ mit dem Kollektoranschluß des ersten bipolaren npn-Transistors T1′ verschaltet. Abschließend ist die Stromspiegelschaltung SP′ über die zweiten Anschlüsse des ersten und zweiten p-Kanal-MOS-Feldeffekttransistors P1′ und P2′ mit der zweiten Versorgungsspannung $V_{CC}$ (in diesem Fall 0 Volt) verbunden. Durch die bipolare Differenzstufe DIFF′ und der angeschlossenen Stromspiegelschaltung SP′ wird ein am Eingang E1′ und E2′ anliegendes ECL-Spannungssignal in einen durch die Stromquelle I1′ bestimmten Strom umgesetzt, der am Ausgang A1′ des Spannungs/Stromwandlers W1 abgegriffen werden kann. Dieser Strom wird in dem Strom/Spannungswandler W2 durch eine mit einem Widerstand $R_G$ rückgekoppelten CMOS-Inverterstufe CMI auf eine Ausgangsspannung verstärkt. Die CMOS-Inverterstufe des Strom/Spannungswandlers W2 wird hierbei aus einem n-Kanal-Enhancement-MOS-Feldeffekttransistors N1′ und einem p-Kanal-Enhancement-MOS-Feldeffekttransistor P3′ gebildet, wobei ein erster Anschluß des n-Kanal-MOS-Feldeffekttransistors N1′ mit der ersten Versorgungsspannung $V_{EE}$ und ein erster Anschluß des p-Kanal-MOS-Feldeffekttransistors P3′ mit der zweiten Versorgungsspannung $V_{CC}$ verschaltet ist. Der Eingang der CMOS-Inverterstufe, der gleichzeitig auch den Eingang E3′ des Strom/Spannungswandlers W2 bildet, ist hierbei zugleich mit den Gateanschlüssendes n- und p-Kanal-MOS-Feldeffekttransistors N1′ und P3′ sowie über den Rückkopplungswiderstand $R_G$ mit dem Ausgang der CMOS-Inverterstufe verschaltet. Weiterhin ist der Ausgang der CMOS-Inverterstufe, der gleichzeitig auch den Ausgang A2′ des Strom/Spannungswandlers W2 bildet, mit einem zweiten Anschluß des n-Kanal-MOS-Feldeffekttransistors N1′ und mit einem zweiten Anschluß des p-Kanal-MOS-Transistors P3′ verbunden. Aufgrund des angewendeten Prinzips des "mismatched amplifiers" zwischen dem Spannungs/Stromwandler W1 und dem Strom/Spannungswandler W2 wird das Potential und der Hub am Ausgang A1′ des Spannungs/Stromwandlers W1 bzw. am Eingang E3′ des Strom/Spannungswandlers W2 durch die CMOS-Inverterstufe CMI mit dem Rückkopplungswiderstand $R_G$ eingestellt, wodurch die Emitterfolger, die nach dem Stand der Technik zwischen dem bipolaren Differenzverstärker und einer CMOS-Inverterstufe notwendig sind, entfallen können. Durch den niederohmigen Eingang E3′ des Strom/Spannungswandlers W2 stabilisiert sich weiterhin der Arbeitspunkt am Ausgang A1′ des Spannungs/Stromwandlers W1 auf ungefähr die Hälfte der ersten Versorgungsspannung ($V_{EE}$/2).

Es treten keine Probleme der Pegelanpassung zwischen dem bipolaren Differenzverstärker und der CMOS-Inverterstufe mehr auf, da man im Gegensatz zu dem ECL-CMOS-Wandler nach Figur 1, mit Stromstärken, die proportional zu den ECL-Eingangsspannungen sind, die CMOS-Inverterstufe CMI ansteuert. Streuungen der Widerstandswerte werden durch eine entsprechende Ansteuerung der Stromquelle I1′ eben-

4

falls ausgeglichen. Aufgrund der Rückkopplung mit Hilfe des Rückkopplungswiderstandes $R_G$ wird jedoch der Ausgangshub am Ausgang A2′ um ungefähr 0,6 Volt unterhalb der ersten Versorgungsspannung $V_{EE}$ liegen.

Zur Dimensionierung des erfindungsgemäßen ECL-CMOS-Wandlers wird in einer ersten Vorgabe der abzugebende Strom $I_Q$ der Stromquelle I1′ festgelegt. Dies erfolgt nach gewünschter Schnelligkeit, möglicher Verlustleistung und vorhandener Chipfläche. Hierdurch ist es möglich, die Kanalweiten der MOS-Feldeffekttransistoren der Stromspiegelschaltung SP′ und die npn-Bipolartransistoren der Differenzstufe DIFF′ zu dimensionieren. In einer zweiten Vorgabe wird ein interner Spannungshub $U_{Hub}$ am Ausgang A1′ des Spannungs/-Stromwandlers W1 (beispielsweise $\pm$ 0,5 Volt) festgelegt. In einer dritten Vorgabe schließlich wird die Restspannung $U_R$ am Ausgang A2′ des Strom/Spannungswandlers W2 abgeschätzt damit die folgenden MOS-Schaltungen auch sicher betrieben werden können. Als ein Beispiel kann für die Restspannung ungefähr 0,6 Volt angenommen werden. Aus der zweiten und dritten Vorgabe schließlich kann der Rückkopplungswiderstand $R_G$ berechnet werden zu

$$R_G = (|V_{EE}/2| - |U_R| + |U_{Hub}|)/I_Q.$$

Aus den Angaben der Versorgungsspannung $V_{EE}$, der Restspannung $U_R$, der Hubspannung $U_{Hub}$ und dem Kennlinienfeld für MOS-Feldeffekttransistoren kann eine Bestimmung der Kanalbreiten für die MOS-Ausgangstransistoren N1′ und P4′ vorgenommen werden.

Bei den angegebenen Spannungsangaben wurde $V_{CC}$ = 0 Volt und $V_{EE}$ ungefähr -4,5 Volt gewählt, jedoch sind auch andere Spannungswerte für $V_{CC}$ und $V_{EE}$ denkbar. Wichtig dabei ist, daß die zweite Versorgungsspannung $V_{CC}$ größer als die erste Versorgungsspannung $V_{EE}$ ist.


## Patentansprüche

1. ECL-CMOS-Wandler zur Wandlung von ECL-Pegel in CMOS-Pegel,
   - bei dem ein Ausgang (A1′) eines Spannungs/Stromwandlers (W1) direkt mit einem Eingang (E3′) eines Strom/Spannungswandlers (W2) verbunden ist,
   - bei dem der Spannungs/Stromwandler (W1) eine Stromquelle (I1′), eine Differenzstufe (DIFF′) und eine Stromspiegelschaltung (SP′) aufweist,
   - bei dem die Differenzstufe einen ersten Bipolartransistor (T1′) und einen zweiten Bipolartransistor (T2′) enthält, deren Emitter-Anschlüsse jeweils über die Stromquelle mit einer ersten Versorgungsspannung ($V_{EE}$) verbunden sind und deren jeweiliger Basisanschluß mit einem jeweiligen Eingang (E1′, E2′) des Spannungs/Stromwandlers und somit des ECL-CMOS-Wandlers verbunden ist,
   - bei dem der Kollektoranschluß des zweiten Bipolartransistors mit einem ersten Anschluß eines ersten MOS-Transistors (P1′) der Stromspiegelschaltung und der Kollektoranschluß des ersten Bipolartransistors mit einem ersten Anschluß eines zweiten MOS-Transistors (P2′) der Stromspiegelschaltung verbunden sind, wobei die zweiten Anschlüsse des ersten und zweiten MOS-Transistors der Stromspiegelschaltung mit einer zweiten Versorgungsspannung ($V_{CC}$), der erste Anschluß des ersten MOS-Transistors mit den Gate-Anschlüssen des ersten und zweiten MOS-Transistors und der erste Anschluß des zweiten MOS-Transistors mit dem Ausgang (A1′) des Spannungs/Stromwandlers verbunden sind,
   - bei dem der Strom/Spannungswandler (W2) eine rückgekoppelte CMOS-Inverterstufe (CMI) enthält, deren Eingang den Eingang (E3′) des Strom/Spannungswandlers, deren Ausgang (A2′) den Ausgang des Strom/Spannungswandlers und somit des ECL-CMOS-Wandlers bildet und deren Ausgang über einen definiert eingefügten Widerstand mit deren Eingang verbunden ist, und
   - bei dem die rückgekoppelte CMOS-Inverterstufe eine Reihenschaltung aus einem MOS-Transistor (P3′) eines ersten Leitungstyps und aus einem MOS-Transistor eines zweiten Leitungstyps (N1′) enthält, wobei ein erster Anschluß des MOS-Transistors des zweiten Leitungstyps mit der ersten Versorgungsspannung und ein erster Anschluß des MOS-Transistors des ersten Leitungstys mit der zweiten Versorgungsspannung verbunden sind, wobei die zweiten Anschlüsse der MOS-Transistoren der CMOS-Inverterstufe mit dem Ausgang des ECL-CMOS-Wandlers und wobei die Gate-Anschlüsse der MOS-Transistoren der CMOS-Inverterstufe mit dem Eingang des Strom/Spannungswandlers verbunden sind.

2. ECL-CMOS-Wandler nach Anspruch 1,
   **dadurch gekennzeichnet,**
   daß die Differenzstufe (DIFF′) zwei bipolare npn-Transistoren (T1′, T2′) enthält.

3. ECL-CMOS-Wandler nach Anspruch 1 oder 2,

**dadurch gekennzeichnet,**
daß die Stromspiegelschaltung (Sp′) zwei Enhancement-p-Kanal-MOS-Feldeffekttransistoren (P1′, P2′) enthält.

4.   ECL-CMOS-Wandler nach einem der Ansprüche 1 bis 3,
**dadurch gekennzeichnet,**
daß die Stromquelle (I1′) als eine MOS-Stromquelle realisiert ist.

5.   ECL-CMOS-Wandler nach einem der vorhergehenden Ansprüche,
**dadurch gekennzeichnet,**
daß die rückgekoppelte CMOS-Inverterstufe (CMI) einen Enhancement-p-Kanal-MOS-Feldeffekttransistor (P3′) und einen Enhancement-n-Kanal-MOS-Feldeffekttransistor (N1′) enthält.

## Claims

1.   ECL-CMOS converter for converting an ECL level into a CMOS level,
- in which an output (A1′) of a voltage-to-current converter (W1) is directly connected to an input (E3′) of a current-to-voltage converter (W2),
- in which the voltage-to-current converter (W1) exhibits a current source (I1′), a differential stage (DIFF′) and a current mirror circuit (SP′),
- in which the differential stage includes a first bipolar transistor (T1′) and a second bipolar transistor (T2′), the emitter connections of which are connected in each instance via the current source to a first supply voltage ($V_{EE}$), and the respective base connection of which is connected to a respective input (E1′, E2′) of the voltage-to-current converter and thus of the ECL-CMOS converter,
- in which the collector connection of the second bipolar transistor is connected to a first connection of a first MOS transistor (P1′) of the current mirror circuit and the collector connection of the first bipolar transistor is connected to a first connection of a second MOS transistor (P2′) of the current mirror circuit, in which the second connections of the first and second MOS transistor of the current mirror circuit are connected to a second supply voltage ($V_{CC}$), the first connection of the first MOS transistor is connected to the gate connections of the first and second MOS transistor and the first connection of the second MOS transistor is connected to the output (A1′) of the voltage-to-current converter,
- in which the current-to-voltage converter (W2) includes a feedback CMOS inverter stage (CMI), the input of which forms the input (E3′) of the current-to-voltage converter, the output (A2′) of which inverter stage forms the output of the current-to-voltage converter and thus of the ECL-CMOS converter and the output of which inverter stage is connected via a defined inserted resistor to its input, and
- in which the feedback CMOS inverter stage includes a series circuit of an MOS transistor (P3′) of a first conductivity type and of an MOS transistor of a second conductivity type (N1′), in which a first connection of the MOS transistor of the second conductivity type is connected to the first supply voltage and a first connection of the MOS transistor of the first conductivity type is connected to the second supply voltage, in which the second connections of the MOS transistors of the CMOS inverter stage are connected to the output of the ECL-CMOS converter and in which the gate connections of the MOS transistors of the CMOS inverter stage are connected to the input of the current-to-voltage converter

2.   ECL-CMOS converter according to Claim 1, characterized in that the differential stage (DIFF′) includes two bipolar npn transistors (T1′, T2′).

3.   ECL-CMOS converter according to Claim 1 or 2, characterized in that the current mirror circuit (SP′) includes two enhancement p-channel MOS field effect transistors (P1′, P2′).

4.   ECL-CMOS converter according to one of Claims 1 to 3, characterized in that the current source (I1′) is constructed as an MOS current source.

5.   ECL-CMOS converter according to one of the preceding claims, characterized in that the feedback CMOS inverter stage (CMI) includes an enhancement p-channel MOS field effect transistor (P3′) and an enhancement n-channel MOS field effect transistor (N1′).

## Revendications

1. Convertisseur ECL-CMOS pour convertir un niveau ECL en un niveau CMOS,
   - dans lequel une sortie (A1′) d'un convertisseur (W1) tension/courant est reliée directement à une entrée (E3′) d'un convertisseur (W2) courant/tension,
   - dans lequel le convertisseur (W1) tension/courant comprend une source (I1′) de courant, un étage (DIFF′) différentiel et un circuit (SP′) miroir de courant,
   - dans lequel l'étage différentiel comprend un premier transistor (T1′) bipolaire et un deuxième transistor (T2′) bipolaire, dont les bornes d'émetteur sont chacune reliées par l'intermédiaire de la source de courant à une première tension ($V_{EE}$) d'alimentation et dont les bornes respectives de base sont reliées à des entrées (E1′, E2′) correspondantes du convertisseur tension/courant et ainsi du convertisseur ECL-CMOS,
   - dans lequel la borne du collecteur du deuxième transistor bipolaire est reliée à une première borne d'un premier transistor (P1′) MOS du circuit miroir de courant et la borne de collecteur du premier transistor bipolaire est reliée à une première borne d'un deuxième transistor (P2′) MOS du circuit miroir de courant, les deuxièmes bornes des premier et deuxième transistors MOS du circuit miroir de courant étant reliées à une deuxième tension ($V_{CC}$) d'alimentation, la première borne du premier transistor MOS étant reliée aux bornes de grille des premier et deuxième transistors MOS et la première borne du deuxième transistor MOS étant reliée à la sortie (A1′) du convertisseur tension/courant,
   - dans lequel le convertisseur (W2) courant/tension comprend un étage (CMI) inverseur CMOS de rétroaction, dont l'entrée forme l'entrée (E3′) du convertisseur courant/tension, dont la sortie (A2′) forme la sortie du convertisseur courant/tension et ainsi du convertisseur ECL-MOS et dont la sortie est reliée à l'entrée par l'intermédiaire d'une résistance déterminée insérée, et
   - dans lequel l'étage CMOS inverseur de rétroaction comprend un circuit série constitué d'un transistor MOS (P3′) ayant un premier type de conduction et d'un transistor MOS (N1′) ayant un second type de conduction, une première borne du transistor MOS de deuxième type de conduction étant reliée à la première tension d'alimentation et une première borne du transistor MOS de premier type de conduction étant reliée à la deuxième tension d'alimentation, les deux bornes des transistors MOS de l'étage CMOS inverseur étant reliées à la sortie du convertisseur ECL-CMOS et les bornes de grille des transistors MOS de l'étage CMOS inverseur étant reliées à l'entrée du convertisseur courant-tension.

2. Convertisseur ECL-CMOS suivant la revendication 1,
   caractérisé en ce que
   l'étage (DIFF′) différentiel comprend deux transistors (T1′, T2′) bipolaires npn.

3. Convertisseur ECL-CMOS suivant la revendication 1 ou 2,
   caractérisé en ce que
   le circuit (Sp′) miroir de courant comprend deux transistors (P1′, P2′) MOS à effet de champ de canal p à enrichissement.

4. Convertisseur ECL-CMOS suivant l'une des revendications 1 à 3,
   caractérisé en ce que
   la source (I1′) de courant est réalisée en tant que source de courant MOS.

5. Convertisseur ECL-CMOS suivant l'une des revendications précédentes,
   caractérisé en ce que
   l'étage (CMI) CMOS inverseur de rétroaction comprend un transistor (P3′) MOS à effet de champ de canal p à enrichissement et un transistor (N1′) MOS à effet de champ de canal n à enrichissement.

FIG 1

FIG 2